# EUROPEAN PATENT APPLICATION

(11) **EP 4 796 937 A1**
(43) Date of publication of application: **26.08.2026**
(21) Application number: 26156239.1
(22) Date of filing: 04.02.2026
(51) Int. Cl.: G01R 31/28, G01R 31/317

(54) **INTEGRATED CIRCUIT INCLUDING TEST CIRCUIT**

(30) Priority: 10.02.2025 KR 20250016974
(71) Applicant: Samsung Electronics Co., Ltd., Suwon-si, Gyeonggi-do 16677 (KR)
(72) Inventor: KIM, Kihong, 16677 Suwon-si (KR); HEO, Donghun, 16677 Suwon-si (KR); YOO, Byoungjoo, 16677 Suwon-si (KR)
(74) Representative: Marks & Clerk LLP

(57) **Abstract**

An integrated circuit is provided. The integrated circuit includes: a voltage-dividing circuit including a plurality of resistors connected to each other in series, wherein the voltage-dividing circuit is configured to generate, based on a test signal, an internal test signal, at least one first reference signal, and at least one second reference signal; a first low-pass filter configured to receive the at least one first reference signal and generate a first reference voltage; a second low-pass filter configured to receive the at least one second reference signal and generate a second reference voltage; a first comparator configured to compare the first reference voltage to the internal test signal; and a second comparator configured to compare the second reference voltage to the internal test signal.

## Description

### BACKGROUND

The present disclosure relates to an integrated circuit including a test circuit.

As semiconductor processes become more precise and the degree of integration within a single die increases, a test method in semiconductor devices becomes an important factor that directly affects yield. Various test methods and measurement methods are being developed to maximize yield. Because a large number of tests and verifications are required, built-in measurement devices may be used to evaluate and test operations of semiconductor devices. Various manufacturers access and control the built-in measurement devices in various ways, and thus, standardization is required to deal with interoperability issues. Accordingly, test standards, such as IEEE 1149.1, 1687, and 1500, have been introduced. These test standards provide standardized interfaces and data models, and thus, efficiency in test and verification processes has been improved. However, there are limitations to satisfying test standards by adjusting offsets of comparators used for tests, and there are also issues that hysteresis characteristics of comparators change significantly according to process, voltage, and temperature (PVT) requirements.

### SUMMARY

One or more example embodiments provide an integrated circuit including a test circuit with a reduced area and capable of operating stably even when process or temperature requirements change.

According to an aspect of an example embodiment, there is provided an integrated circuit including: a voltage-dividing circuit including a plurality of resistors connected to each other in series, wherein the voltage-dividing circuit is configured to generate, based on a test signal, an internal test signal, at least one first reference signal, and at least one second reference signal; a first low-pass filter configured to receive the at least one first reference signal and generate a first reference voltage; a second low-pass filter configured to receive the at least one second reference signal and generate a second reference voltage; a first comparator configured to compare the first reference voltage to the internal test signal; and a second comparator configured to compare the second reference voltage to the internal test signal.

According to another aspect of an example embodiment, there is provided an integrated circuit including: a high-pass filter configured to receive a test signal and generate an internal test signal, at least one first reference signal, and at least one second reference signal; a first low-pass filter configured to receive the at least one first reference signal and generate a first reference voltage; a second low-pass filter configured to receive the at least one second reference signal and generate a second reference voltage; a first comparator configured to compare the first reference voltage to the internal test signal; and a second comparator configured to compare the second reference voltage to the internal test signal.

According to another aspect of an example embodiment, there is provided an integrated circuit which operates in a plurality of test modes, the integrated circuit including: a voltage-dividing circuit including a plurality of resistors connected to each other in series, wherein the voltage-dividing circuit is configured to generate an internal test signal, a first reference signal, and a second reference signal; a first low-pass filter configured to receive the first reference signal and generate a first reference voltage; a second low-pass filter configured to receive the second reference signal and generate a second reference voltage; a first comparator configured to compare the first reference voltage to the internal test signal; and a second comparator configured to compare the second reference voltage to the internal test signal. The voltage-dividing circuit is further configured to operate as a high-pass filter in a first test mode among the plurality of test modes.

According to another aspect of an example embodiment, there is provided a method of controlling a test operation of an integrated circuit, the method including: controlling, based on a test signal, a voltage-dividing circuit including a plurality of resistors connected to each other in series to generate an internal test signal, a first reference signal and a second reference signal; generating, by a first low-pass filter, a first reference voltage based on the first reference signal; generating, by a second low-pass filter, a second reference voltage based on the second reference signal; comparing the first reference voltage to the internal test signal; and comparing the second reference voltage to the internal test signal.

At least some of the above and other features of the invention are set out in the claims.

### BRIEF DESCRIPTION OF DRAWINGS

The above and other objects and features will be more clearly understood from the following description of example embodiments, taken in conjunction with the accompanying drawings in which:
FIG. 1 is a block diagram showing an integrated circuit including a test circuit according to an example embodiment;
FIG. 2 is a diagram illustrating a test circuit according to an example embodiment;
FIG. 3 is a drawing illustrating waveforms of signals that are input to and generated by a test circuit according to an example embodiment;
FIG. 4 is a diagram illustrating a test circuit according to an example embodiment;
FIG. 5 is a diagram illustrating a test circuit according to an example embodiment;
FIG. 6 is a diagram illustrating reference signals generated by a voltage-dividing circuit;
FIG. 7 is a diagram illustrating a test circuit according to an example embodiment;
FIG. 8 is an example circuit diagram of a comparator included in a test circuit according to an example embodiment, for example, a first comparator or a second comparator;
FIG. 9 is an example circuit diagram of a hysteresis comparator included in a test circuit according to an example embodiment; and
FIG. 10 is a block diagram illustrating an electronic device according to an example embodiment.

### DETAILED DESCRIPTION

Hereinafter, example embodiments are described in detail with reference to the accompanying drawings. Each embodiment provided in the following description is not excluded from being associated with one or more features of another example or another embodiment also provided herein or not provided herein but consistent with the present disclosure. It will be understood that when an element is referred to as being "connected to" or "coupled to" another element, it can be directly connected or coupled to the other element, or intervening elements may be present. By contrast, when an element is referred to as being "directly connected to" or "directly coupled to" another element, there are no intervening elements present.

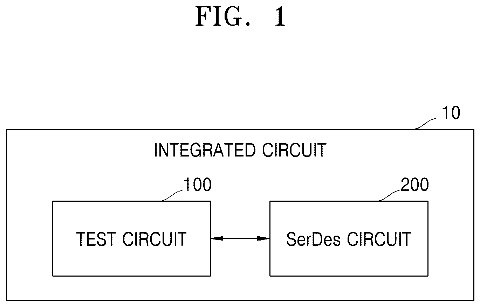

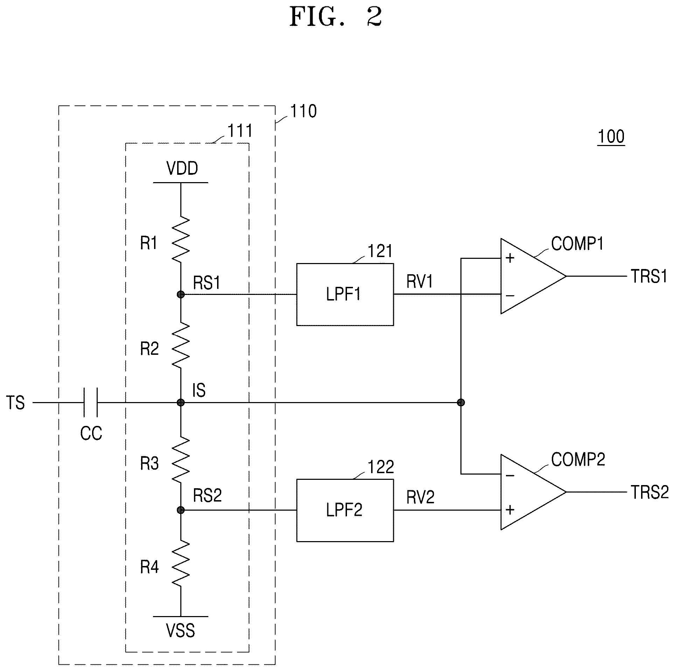

FIG. 1 is a block diagram showing an integrated circuit 10 including a test circuit 100 according to an example embodiment. FIG. 2 is a diagram illustrating the test circuit 100 according to an example embodiment.

Referring to FIG. 1, the integrated circuit 10 may constitute a semiconductor device that performs various functions. The integrated circuit 10 may include a chip or a die, or may include a semiconductor package including at least one chip or die. For example, the semiconductor device including the integrated circuit 10 may include a memory device. The semiconductor device may include, but is not limited to, one or more of static random-access memory (SRAM), dynamic random-access memory (DRAM), mobile DRAM, flash memory, electrically erasable programmable read-only memory (EEPROM), phase-change RAM (PRAM), resistive RAM (RRAM), and ferroelectric RAM (FRAM). As an example, the semiconductor device including the integrated circuit 10 may include a system semiconductor device. The semiconductor device may include one or more of a central processing unit (CPU), an application processor (AP), a graphics processing unit (GPU), a multimedia semiconductor device, a sensor, an artificial intelligence (AI) semiconductor device, etc. In addition or alternatively, the semiconductor device may include a system on a chip (SoC).

The integrated circuit 10 may include a serializer/deserializer (SerDes) circuit 200 and the test circuit 100. The test circuit 100 may include a test circuit for performing a boundary scan test of the integrated circuit 10. The test circuit 100 may be referred to as a joint test action group (JTAG) circuit.

The SerDes circuit 200 may constitute a transmission system in which a signal is transmitted from a transmitter of an integrated circuit to a receiver of another integrated circuit via a high-speed connection, and may reduce the number of physical wires. In an example embodiment, the SerDes circuit 200 may include a receiver and a transmitter. The receiver may include an analog front end (AFE) circuit, a decision feedback equalization (DFE) circuit, a clock and data recovery (CDR) circuit, and/or a deserializer. The transmitter may include a serializer, an output driver, and/or a phase-locked loop (PLL) circuit.

The integrated circuit 10 may receive test data from the outside. An external logic module (e.g., a JTAG interface) of the integrated circuit 10 may activate a data transmission path for testing the integrated circuit 10 and may transmit signals at a target data rate.

The integrated circuit 10 may include a plurality of terminals for interfacing with the external logic module. The external logic module may set the test circuit 100 of the integrated circuit 10 via a test access port (TAP) of the integrated circuit 10 or may generate a test result signal. For example, the integrated circuit 10 may include a plurality of terminals for interfacing with an external JTAG interface. The integrated circuit 10 may also include a terminal for receiving a test mode selection signal, a terminal for outputting test data, a terminal for inputting test data, or a terminal for resetting test data.

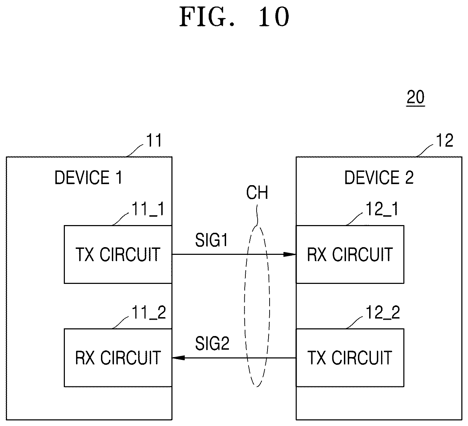

The test circuit 100 may generate a test result signal according to a result of comparison between an internal test signal and a reference voltage. Based on the test result signal, a defect in a channel between the integrated circuit 10 and the external logic module may be detected. The defects that may be detected from the test result signal are described in detail with reference to FIG. 10.

Referring to FIG. 2, the test circuit 100 may receive a test signal TS and output a first test result signal TRS1 and a second test result signal TRS2. For example, each of the first test result signal TRS1 and the second test result signal TRS2 may be generated by the test circuit 100 based on the test signal TS. The test circuit 100 may include a high-pass filter 110 that receives the test signal TS and generates an internal test signal IS. The high-pass filter 110 may include a coupling capacitor CC and a plurality of resistors (e.g., R1 to R4).

The plurality of resistors R1 to R4 (or referred to as first to fourth resistors R1 to R4) may operate as a voltage-dividing circuit 111. That is, the voltage-dividing circuit 111 may include the plurality of resistors R1 to R4 that are connected to each other in series between a power supply voltage VDD (e.g., a power supply node) and a ground voltage VSS (e.g., a ground node). In this case, the resistance of each of the plurality of resistors R1 to R4 may be determined according to the characteristics of the high-pass filter 110. Also, the resistance of each of the plurality of resistors R1 to R4 may be determined according to the characteristics of a first reference signal RS1 and a second reference signal RS2 generated in the voltage-dividing circuit 111.

The test circuit 100 may include a first low-pass filter 121, which receives the first reference signal RS1 and generates a first reference voltage RV1 based on the first reference signal RS1, and a second low-pass filter 123, which receives the second reference signal RS2 and generates a second reference voltage RV2 based on the second reference signal RS2. Here, the first reference voltage RV1 may have a value that is greater than a common level of the internal test signal IS by a specific voltage level, and the second reference voltage RV2 may have a value that is less than the common level of the internal test signal IS by a specific voltage level.

The test circuit 100 may include a first comparator COMP1, which compares the first reference voltage RV1 to the internal test signal IS, and a second comparator COMP2, which compares the second reference voltage RV2 to the internal test signal IS. The first comparator COMP1 may output the first test result signal TRS1 according to the comparison result, and the second comparator COMP2 may output the second test result signal TRS2 according to the comparison result. In an example embodiment, the first comparator COMP1 and the second comparator COMP2 may include non-hysteresis comparators that do not have (or exclude) hysteresis characteristics.

A comparator that has no hysteresis characteristics may output a comparison result based on a direct comparison between first and second input signals without any hysteresis (e.g., without any offset). For instance, where the first input signal is greater than the second input signal, an output signal having a logic high level (e.g., a high output signal, such as '1') may be output, and where the first input signal is not greater than the second input signal, an output signal having a logic low level (e.g., a low output signal, such as '0') may be output.

In contrast, a comparator that has hysteresis characteristics may apply hysteresis (e.g., offsets/hysteresis values) to the comparison between the first and second input signals. The comparator may output an output signal having a logic high level (e.g., a high output signal, such as '1') when the first input signal is greater than the sum of the second input signal and a first offset value (e.g., a first hysteresis value). The comparator may output an output signal having a logic low level (e.g., a low output signal, such as '0') when the first input signal is less than or equal to the value obtained by subtracting a second offset value (e.g., a second hysteresis value) from the second input signal.

In a boundary scan test operation, hysteresis characteristics may be required for a comparison operation performed by each of the first comparator COMP1 and the second comparator COMP2 in the test circuit 100 to distinguish noise components contained in the test signal TS. The hysteresis characteristics required in the comparison operation may be defined in the IEEE 1149.6 standard, and hysteresis having about 50 % to about 90 % of the magnitude of an input signal may be required. In the first comparator COMP1 and the second comparator COMP2 themselves, it may be somewhat difficult to satisfy the hysteresis characteristics required by the IEEE 1149.6 standard. In addition, when a hysteresis comparator having hysteresis characteristics is compared to a comparator not having the hysteresis characteristics, the hysteresis comparator may change in hysteresis characteristics according to changes in process or temperature requirements. In particular, as supply voltages provided for operations of semiconductor devices have been gradually reduced recently, an operating range for stably operating the first comparator COMP1 and the second comparator COMP2 may become narrower, and an operating range of the test signal TS may also become narrower.

In the test circuit 100 according to an example embodiment, the first reference voltage RV1 and the second reference voltage RV2, having levels that are offset from the common level of the internal test signal IS by specific voltage levels, may be generated by using the voltage-dividing circuit 111 that constitutes the high-pass filter 110 for generating the internal test signal IS. The first reference voltage RV1 and the second reference voltage RV2 may be used as reference voltages for testing defects by using the internal test signal IS in the first comparator COMP1 and the second comparator COMP2, respectively.

Therefore, even when each of the first comparator COMP1 and the second comparator COMP2 does not have hysteresis characteristics, the hysteresis characteristics of the test circuit 100 may be adjusted by adjusting the magnitudes of the first reference voltage RV1 and the second reference voltage RV2. Therefore, the hysteresis characteristics required in the comparison operation are not limited by the characteristics of each of the first comparator COMP1 and the second comparator COMP2, but may be satisfied by generating the first reference voltage RV1 and the second reference voltage RV2. Accordingly, the hysteresis characteristics may be maintained stably even when the process or temperature requirements of each of the first comparator COMP1 and the second comparator COMP2 vary. Therefore, the test circuit 100 may perform a test operation of reliably detecting defects even with changes in process or temperature requirements.

In an example embodiment, the first comparator COMP1 and the second comparator COMP2 may include hysteresis comparators that have the hysteresis characteristics. Even when the hysteresis characteristics of the first comparator COMP1 and the second comparator COMP2 themselves are sensitive to changes in process or temperature requirements, the hysteresis characteristics of the comparison operation in the test circuit 100 may be maintained stably because the first reference voltage RV1 and the second reference voltage RV2 are stably generated in the voltage-dividing circuit 111.

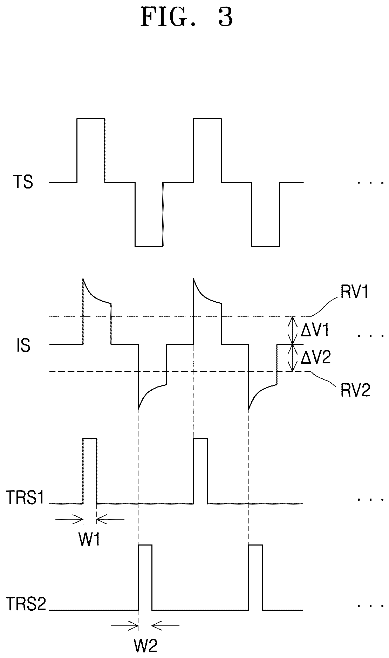

FIG. 3 is a drawing illustrating waveforms of signals that are input to and generated by the test circuit 100 according to an example embodiment.

Referring to FIGS. 2 and 3, the test circuit 100 may receive the test signal TS of a pulse wave having a specific period in an alternating current (AC) test mode. In the test signal TS, pulses with positive values and pulses with negative values may be repeated.

The first reference voltage RV1 may have a value that is higher than the common level of the internal test signal IS by a first voltage level ΔV1. The second reference voltage RV2 may have a value that is lower than the common level of the internal test signal IS by a second voltage level ΔV2. In an example embodiment, the magnitude of the first voltage level ΔV1 may be equal to the magnitude of the second voltage level ΔV2. In an example embodiment, in the voltage-dividing circuit 111, the resistance of the second resistor R2 may be equal to the resistance of the third resistor R3.

The first comparator COMP1 may generate the first test result signal TRS1 according to the comparison result. The first comparator COMP1 may generate the first test result signal TRS1 of a pulse having a first width W1 from the time the internal test signal IS becomes greater than the first reference voltage RV1. In this case, the first width W1 may have a pre-specified value.

The second comparator COMP2 may generate the second test result signal TRS2 according to the comparison result. The second comparator COMP2 may generate the second test result signal TRS2 of a pulse having a second width W2 from the time the internal test signal IS becomes less than the second reference voltage RV2. In this case, the second width W2 may have a pre-specified value.

In the test circuit 100 according to an example embodiment, the first reference voltage RV1 having a level higher than the common level of the internal test signal IS by the first voltage level ΔV1 is generated, the second reference voltage RV2 having a level lower than the common level of the internal test signal IS by the second voltage level ΔV2 is generated, and the first reference voltage RV1 and the second reference voltage RV2 are compared to the internal test signal IS. Accordingly, the noise contained in the internal test signal IS may be distinguished, and thus, the comparison operation is possible.

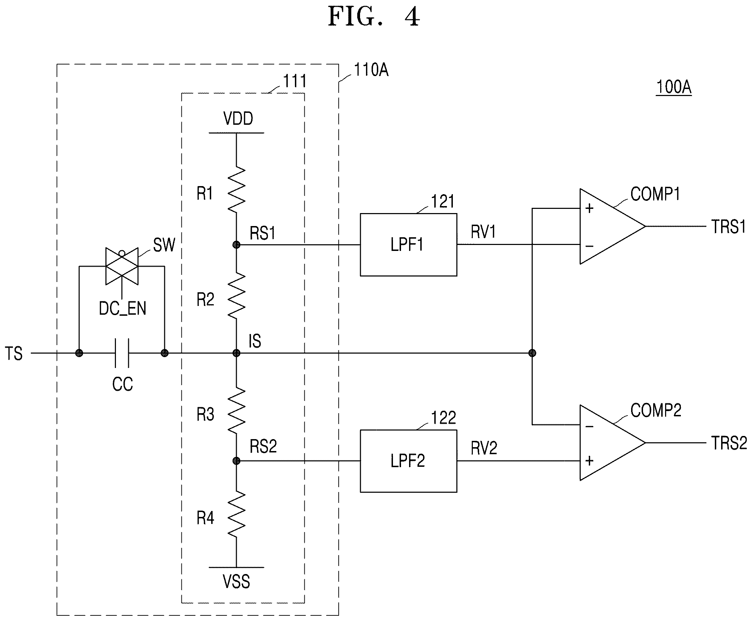

FIG. 4 is a diagram illustrating a test circuit 100A according to an example embodiment. In descriptions with reference to FIG. 4, repeated descriptions of the same reference numerals as those in FIG. 2 are omitted.

Referring to FIG. 4, the test circuit 100A may receive a test signal TS and output a first test result signal TRS1 and a second test result signal TRS2. The test circuit 100A may include a high-pass filter 110A, the first low-pass filter 121, a second low-pass filter 122, the first comparator COMP1, and the second comparator COMP2.

The test circuit 100A may include the high-pass filter 110A that receives the test signal TS and generates the internal test signal IS. The high-pass filter 110A may include the coupling capacitor CC, a switching circuit SW, and the voltage-dividing circuit 111.

The switching circuit SW may be connected to the coupling capacitor CC in parallel. The switching circuit SW may be switched in response to an enable signal DC_EN. In an example embodiment, the switching circuit SW may be implemented as a transmission gate and may be switched by the enable signal DC_EN and a complementary enable signal. The complementary enable signal may be complementary to the enable signal DC_EN and have a phase opposite to a phase of the enable signal DC_EN.

The test circuit 100A may operate in a plurality of test modes. For example, the test circuit 100A may operate in a direct current (DC) test mode or an alternating current (AC) test mode. In the DC test mode, the test signal TS may be a DC signal. In the AC test mode, the test signal TS may be an AC signal having a specific pulse waveform at a certain cycle.

In the DC test mode, the switching circuit SW may be turned on in response to the enable signal DC_EN, and the test signal TS may be provided, as the internal test signal IS, to the first comparator COMP1 and the second comparator COMP2. In the AC test mode, the switching circuit SW may be turned off in response to the enable signal DC_EN, and the test circuit 100A may operate as described above with reference to FIG. 2.

A test circuit according to a comparative example generates reference voltages such that the reference voltages are used for comparison to the test signal TS only in the DC test mode, and thus further includes a separate reference voltage generation circuit. On the other hand, the test circuit 100A according to an example embodiment is not provisioned with a separate reference voltage generation circuit necessary for operating in the DC test mode, and may generate the first reference voltage RV1 and the second reference voltage RV2 in the AC test mode by using the voltage-dividing circuit 111 that constitutes the high-pass filter 110A. Therefore, the test circuit 100A may operate in both the DC test mode and the AC test mode, and the area of the test circuit 100A may be reduced.

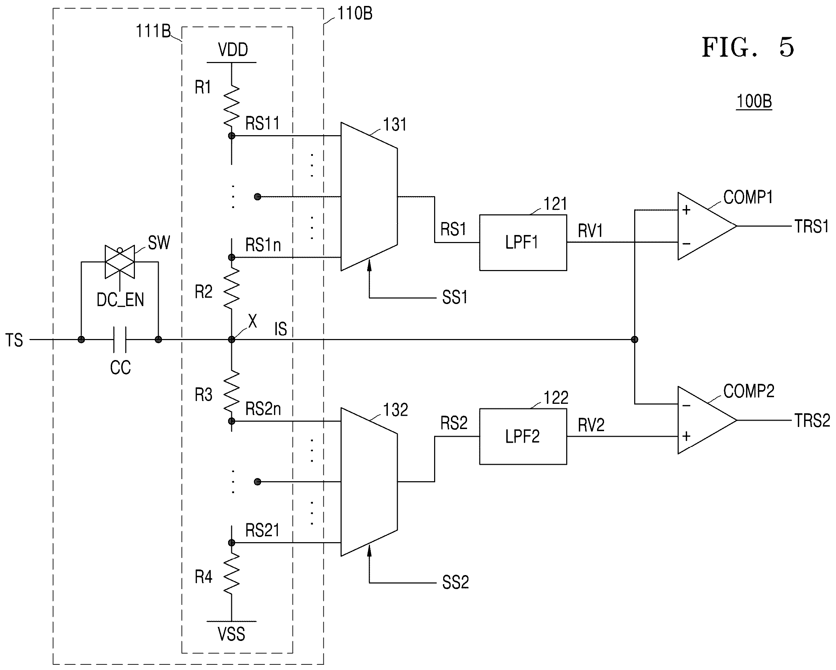

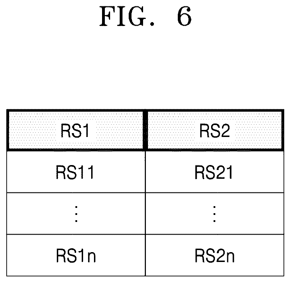

FIG. 5 is a diagram illustrating a test circuit 100B according to an example embodiment. FIG. 6 is a diagram illustrating reference signals generated by a voltage-dividing circuit 111B. In descriptions with reference to FIG. 5, repeated descriptions of the same reference numerals as those in FIG. 2 are omitted.

Referring to FIG. 5, the test circuit 100B may receive the test signal TS and output the first test result signal TRS1 and the second test result signal TRS2. For example, each of the first test result signal TRS1 and the second test result signal TRS2 may be generated by the test circuit 100B based on the test signal TS. The test circuit 100B may include a high-pass filter 110B, a first selection circuit 131, a second selection circuit 132, the first low-pass filter 121, the second low-pass filter 122, the first comparator COMP1, and the second comparator COMP2.

The high-pass filter 110B may include the coupling capacitor CC, the switching circuit SW, and the voltage-dividing circuit 111B. The voltage-dividing circuit 111B may generate the internal test signal IS, a plurality of first reference signals RS11 to RS1n and a plurality of second reference signals RS21 to RS2n (where n is a natural number of 2 or more). The voltage-dividing circuit 111 may include the plurality of resistors (e.g., R1 to R4) that are connected to each other in series between the power supply voltage VDD and the ground voltage VSS. The resistance of each of the plurality of resistors (e.g., R1 to R4) may be determined according to the characteristics of the high-pass filter 110B. The resistance of each of the plurality of resistors R1 to R4 may be determined according to the characteristics of the plurality of first reference signals RS11 to RS1n and the plurality of second reference signals RS21 to RS2n which are generated in the voltage-dividing circuit 111B.

The first selection circuit 131 may select one of the plurality of first reference signals RS11 to RS1n and output the selected first reference signal RS1 to the first low-pass filter 121. The first selection circuit 131 may perform a selection operation in response to a first selection signal SS1 provided from the outside of the test circuit 100B (e.g., from an external device). In an example embodiment, the first selection circuit 131 may be implemented as a multiplexer.

The hysteresis characteristics of the comparison operation performed by the first comparator COMP1 may vary depending on which of the plurality of first reference signals RS11 to RS1n is selected as the selected first reference signal RS1. For example, when the first reference signal RS11 having the highest voltage level among the plurality of first reference signals RS11 to RS1n is selected, large hysteresis characteristics may be obtained, compared to when the first reference signal RS1n having the lowest voltage level among the plurality of first reference signals RS11 to RS1n is selected.

The second selection circuit 132 may select one of the plurality of second reference signals RS21 to RS2n and output the selected second reference signal RS2 to the second low-pass filter 122. The second selection circuit 132 may perform a selection operation in response to a second selection signal SS2 provided from the outside of the test circuit 100B (e.g., from an external device). In an example embodiment, the second selection circuit 132 may be implemented as a multiplexer.

The hysteresis characteristics of the comparison operation performed by the second comparator COMP2 may vary depending on which of the plurality of second reference signals RS21 to RS2n is selected as the selected second reference signal RS2. For example, when the second reference signal RS21 having the lowest voltage level among the plurality of second reference signals RS21 to RS2n is selected, large hysteresis characteristics may be obtained, compared to when the second reference signal RS2n having the highest voltage level among the plurality of second reference signals RS21 to RS2n is selected.

Therefore, in order to test the integrated circuit including the test circuit 100B according to an example embodiment, a user may select a desired first reference signal from among the plurality of first reference signals RS11 to RS1n and select a desired second reference signal from among the plurality of second reference signals RS21 to RS2n. Therefore, the test requirements desired by the user may be provided, and the hysteresis level defined in accordance with the IEEE 1149.6 standard may be satisfied.

Referring to FIGS. 5 and 6, the number of plurality of first reference signals RS11 to RS1n generated by the voltage-dividing circuit 111B and received by the first selection circuit 131 may be equal to the number of plurality of second reference signals RS21 to RS2n received by the second selection circuit 132. A first reference signal RS1 among the plurality of first reference signals RS11 to RS1n and a second reference signal RS2 among the plurality of second reference signals RS21 to RS2n may form a pair of signals, and the first selection circuit 131 and the second selection circuit 132 may each select and output a pair of the first reference signal RS1 and the second reference signal RS2.

In an example embodiment, pairs of signals may be formed sequentially from signals, generated at nodes close to a node X at which the internal test signal IS is generated, among the plurality of first reference signals RS11 to RS1n and the plurality of second reference signals RS21 to RS2n. For example, one pair of signals may be formed by (RS11, RS21), and another pair of signals may be formed by (RS1n, RS2n). In an example embodiment, the first reference voltage RV1 and the second reference voltage RV2 generated according to the selected first reference signal RS1 and the selected second reference signal RS2, respectively, may have levels that are offset from the common level of the internal test signal IS by the same voltage level. However, example embodiments are not limited thereto. The first reference voltage RV1 and the second reference voltage RV2 generated according to the selected first reference signal RS1 and the selected second reference signal RS2, respectively, may have levels that are offset from the common level of the internal test signal IS by different voltage levels, considering the characteristics of noise.

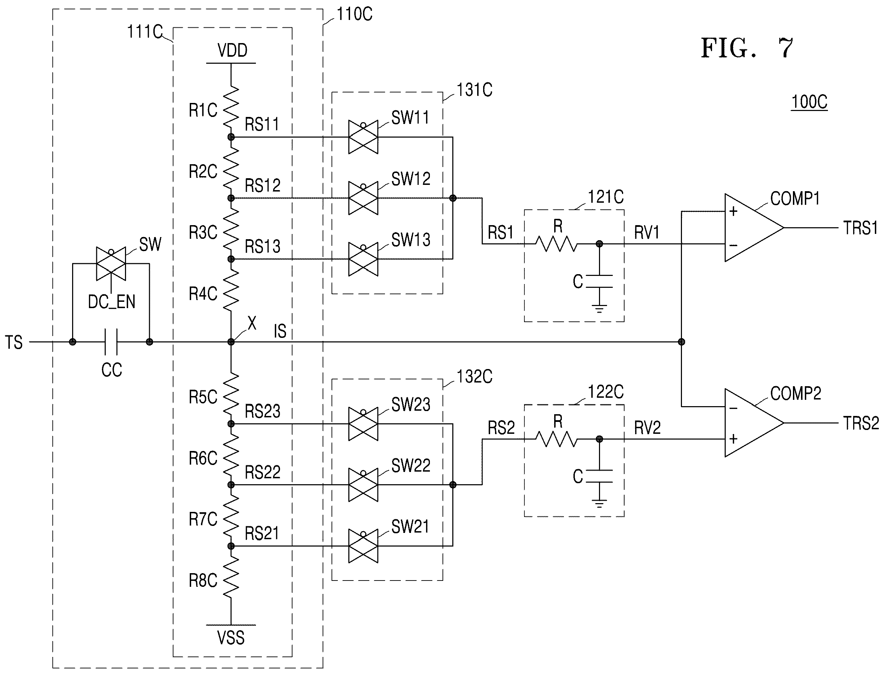

FIG. 7 is a diagram illustrating a test circuit 100C according to an example embodiment. In descriptions with reference to FIG. 7, repeated descriptions of the same reference numerals as those in FIG. 2 are omitted.

Referring to FIG. 7, the test circuit 100C may receive the test signal TS and output the first test result signal TRS1 and the second test result signal TRS2. For example, each of the first test result signal TRS1 and the second test result signal TRS2 may be generated by the test circuit 100C based on the test signal TS. The test circuit 100C includes a high-pass filter 110C, a first selection circuit 131C, a second selection circuit 132C, a first low-pass filter 121C, a second low-pass filter 122C, the first comparator COMP1, and the second comparator COMP2.

The high-pass filter 110C may include the coupling capacitor CC, the switching circuit SW, and a voltage-dividing circuit 111C. The voltage-dividing circuit 111C may generate the internal test signal IS, a plurality of first reference signals (e.g., RS11 to RS13), and a plurality of second reference signals (e.g., RS21 to RS23). FIG. 7 illustrates that the voltage-dividing circuit 111C generates three first reference signals RS11 to RS13 and three second reference signals RS21 to RS23, but example embodiments are not limited thereto. The number of first reference signals and the number of second reference signals generated by the voltage-dividing circuit 111C may vary.

The voltage-dividing circuit 111C may include the plurality of resistors (e.g., R1C to R8C) that are connected to each other in series between the power supply voltage VDD and the ground voltage VSS. The resistance of each of the plurality of resistors (e.g., R1C to R8C) may be determined according to the characteristics of the high-pass filter 110C and/or may be determined according to the characteristics of the plurality of first reference signals RS11 to RS13 and the plurality of second reference signals RS21 to RS23 which are generated in the voltage-dividing circuit 111C.

The first selection circuit 131C may select one of the plurality of first reference signals RS11 to RS13 and output the selected first reference signal RS1 to the first low-pass filter 121C. In an example embodiment, the first selection circuit 131C may include a plurality of switching circuits SW11 to SW13, control the plurality of switching circuits SW11 to SW13, and perform a selection operation in response to a switching signal provided from the outside of the test circuit 100C (e.g., from an external device). The selected first reference signal RS1 may be determined according to a switching circuit that turns on among the plurality of switching circuits SW11 to SW13. For example, a single switch among the plurality of switching circuits SW11 to SW13 may be turned on.

The second selection circuit 132C may select one of the plurality of second reference signals RS21 to RS23 and output the selected second reference signal RS2 to the second low-pass filter 122C. The second selection circuit 132C may include a plurality of switching circuits SW21 to SW23, control the plurality of switching circuits SW21 to SW23, and perform a selection operation in response to a switching signal provided from the outside of the test circuit 100C (e.g., from an external device). The selected second reference signal RS2 may be determined according to a switching circuit that turns on among the plurality of switching circuits SW21 to SW23. For example, a single switch among the plurality of switching circuits SW21 to SW23 may be turned on.

The hysteresis characteristics of the comparison operation performed by the first comparator COMP1 may vary depending on which of the plurality of second reference signals RS21 to RS23 is selected as the selected second reference signal RS2. The hysteresis characteristics of the comparison operation performed by the second comparator COMP2 may vary depending on which of the plurality of second reference signals RS21 to RS23 is selected as the selected second reference signal RS2.

A first reference signal RS1 among the plurality of first reference signals RS11 to RS13 and a second reference signal RS2 among the plurality of second reference signals RS21 to RS23 may form a pair of signals, and the first selection circuit 131C and the second selection circuit 132C may each select and output a pair of the first reference signal RS1 and the second reference signal RS2.

In an example embodiment, pairs of signals may be formed sequentially from signals, generated at nodes close to the node X at which the internal test signal IS is generated, among the plurality of first reference signals RS11 to RS13 and the plurality of second reference signals RS21 to RS23. For example, a pair of signals may be formed by each of (RS11, RS21), (RS12, RS22), and (RS13, RS23).

In an example embodiment, the first reference voltage RV1 and the second reference voltage RV2 generated according to the selected first reference signal RS1 and the selected second reference signal RS2, respectively, may have levels that are offset from the common level of the internal test signal IS by the same voltage level. In this case, some of the plurality of resistors (e.g., R1C to R8C) may have the same resistances symmetrically with respect to the node X. For example, the resistor R4C may have the same resistance value as the resistor R5C, the resistor R3C may have the same resistance value as the resistor R6C, and the resistor R2C may have the same resistance value as the resistor R7C. However, example embodiments are not limited thereto, and the plurality of resistors R1C to R8C may be modified to have various resistance values.

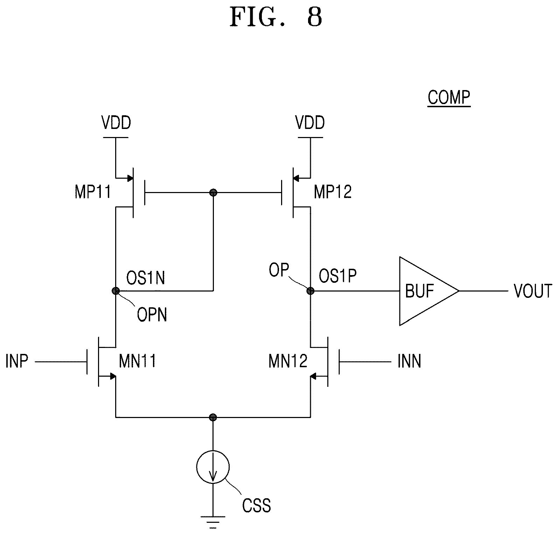

FIG. 8 is an example circuit diagram of a comparator COMP according to an example embodiment. For example, the comparator COMP may be included in the test circuit according to an example embodiment. For example, the comparator COMP may be implemented as the first comparator COMP1 and/or the second comparator COMP2. The comparator COMP in FIG. 8 is an example of a comparator without the hysteresis characteristics, but example embodiments are not limited thereto.

Referring to FIG. 8, the comparator COMP may include a plurality of transistors (for example, MP11, MP12, MN11, and MN12), and a current source CSS. The plurality of transistors may include a first P-type transistor MP11, a second P-type transistor MP12, a first N-type transistor MN11, and a second N-type transistor MN12. For example, the current source CSS may be implemented as an N-type transistor, i.e., an N-type metal oxide semiconductor field effect transistor (MOSFET), and one end thereof may be connected to a ground voltage and generate a bias current.

The gate of the first N-type transistor MN11 and the gate of the second N-type transistor MN12 may receive differential inputs, such as a first input signal INP and a second input signal INN, respectively. Also, the first N-type transistor MN11 and the second N-type transistor MN12 may generate a differential current corresponding to the difference in levels between the first input signal INP and the second input signal INN. For example, when the comparator COMP represents the first comparator COMP1 shown in FIG. 2, the internal test signal IS may be received as the first input signal INP, and the first reference voltage RV1 may be received as the second input signal INN. Also, for example, when the comparator COMP represents the second comparator COMP2 shown in FIG. 2, the second reference voltage RV2 may be received as the first input signal INP, and the internal test signal IS may be received as the second input signal INN.

One end (e.g., the source) of the first N-type transistor MN11 may be connected to the current source CSS, and the other end (e.g., the drain) of the first N-type transistor MN11 may be connected to a second output node OPN. One end (e.g., the source) of the second N-type transistor MN12 may be connected to the current source CSS, and the other end (e.g., the drain) of the second N-type transistor MN12 may be connected to a first output node OP. The first N-type transistor MN11 and the second N-type transistor MN12 may be referred to as a first input transistor and a second input transistor, respectively.

When the first input signal INP is the same as the second input signal INN, the same current may flow through the first N-type transistor MN11 and the second N-type transistor MN12. When the first input signal INP is different from the second input signal INN, different currents may flow through the first N-type transistor MN11 and the second N-type transistor MN12. The sum of the currents flowing through the first N-type transistor MN11 and the second N-type transistor MN12 may be equal to the bias current of the current source CSS.

One end (e.g., the source) of the first P-type transistor MP11 may be supplied with the power supply voltage VDD, and the other end (e.g., the drain) of the first P-type transistor MP11 may be connected to an output node (e.g., the second output node OPN) that outputs a second output signal OS1N (e.g., may be connected to the drain of the first N-type transistor MN11). One end (e.g., the source) of the second P-type transistor MP12 may be supplied with the power supply voltage VDD, and the other end (e.g., the drain) of the second P-type transistor MP12 may be connected to an output node OP (e.g., the first output node OP) that outputs a first output signal OS1P (e.g., may be connected to the drain of the second N-type transistor MN12). The first P-type transistor MP11 and the second P-type transistor MP12 may be referred to as a first load transistor and a second load transistor, respectively.

The first output signal OS1P and the second output signal OS1N may be determined according to current mirroring of the first P-type transistor MP11 and the second P-type transistor MP12. The first output signal OS1P and the second output signal OS1N may be determined based on the amount of current flowing through the first N-type transistor MN11 and the second N-type transistor MN12. When the level of the first input signal INP is higher than that of the second input signal INN, a relatively large amount of current may flow through the first N-type transistor MN11 compared to the second N-type transistor MN12. Accordingly, the level of the first output signal OS1P may increase, and the level of the second output signal OS1N may decrease.

The comparator COMP may further include a buffer BUF. The buffer BUF may receive the first output signal OS1P and generate an output signal VOUT. The output signal VOUT may represent the first test result signal TRS1 or the second test result signal TRS2 as described with reference to FIG. 2, etc.

In the integrated circuit including the test circuit according to an example embodiment, the reference voltages for testing the internal test signal are generated by using the voltage-dividing circuit that includes the plurality of resistors connected to each other in series and constitutes the high-pass filter, and thus, even when the comparator COMP having no hysteresis characteristics is used, the hysteresis characteristics of the comparison operation may be formed by using the reference voltages.

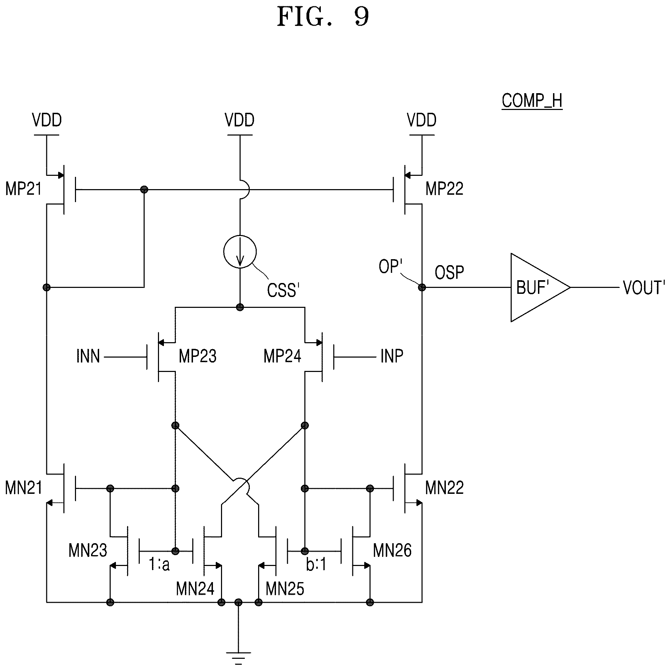

FIG. 9 is an example circuit diagram of a hysteresis comparator COMP_H according to an example embodiment. For example, the hysteresis comparator COMP_H may be included in the test circuit according to an example embodiment. For example, the hysteresis comparator COMP_H may be implemented as the first comparator COMP1 and/or the second comparator COMP2. The hysteresis comparator COMP_H in FIG. 9 is an example of a hysteresis comparator having hysteresis characteristics, but example embodiments are not limited thereto.

Referring to FIG. 9, the hysteresis comparator COMP_H may include a plurality of transistors MP21, MP22, MP23, MP24, MN21, MN22, MN23, MN24, MN25, and MN26 (otherwise referred to as first to fourth P-type transistors MP21 to MP24 and first to sixth N-type transistors MN21 to MN26) and a current source CSS'. For example, the current source CSS may be implemented as a P-type transistor, i.e., a P-type MOSFET, and one end thereof may be connected to the power supply voltage VDD to generate a bias current.

The design of the hysteresis comparator COMP_H may be similar to that of the comparator COMP, with a first P-type transistor MP21 and a first N-type transistor MN21 connected in parallel to a second P-type transistor MP22 and a second N-type transistor MN22; however, the gates of the first N-type transistor MN21 and the second N-type transistor MN22 may not be directly connected to the first input INP or second input INN. Instead, the gate of the first N-type transistor MN21 may be connected to a first node between the third P-type transistor MP23 and the third N-type transistor MN23. Similarly, the gate of the second N-type transistor MN22 may be connected to a second node between the fourth P-type transistor MP24 and the sixth N-type transistor MN26. Furthermore, the sources of the first N-type transistor MN21 and the second N-type transistor MN22 may be connected to ground.

One end (e.g., the drain) of the third N-type transistor MN23 may be connected to the first node and the other end (e.g., the source) of the third N-type transistor MN23 may be connected to ground. One end (e.g., the drain) of the sixth N-type transistor MN26 may be connected to the second node and the other end (e.g., the source) of the sixth N-type transistor MN26 may be connected to ground. One end (e.g., the drain) of the fourth N-type transistor MN24 may be connected to the second node and the other end (e.g., the source) of the fourth N-type transistor MN24 may be connected to ground. One end (e.g., the drain) of the fifth N-type transistor MN25 may be connected to the first node and the other end (e.g., the source) of the fifth N-type transistor MN25 may be connected to ground. The gates of the third N-type transistor MN23 and the fourth N-type transistor MN24 may be connected to the first node. The gates of the fifth N-type transistor MN24 and the sixth N-type transistor MN26 may be connected to the second node.

One end (e.g., the source) of the third P-type transistor MP23 may be connected to the current source CSS' and the other end (e.g., the drain) of the third P-type transistor MP23 may be connected to the first node. One end (e.g., the source) of the fourth P-type transistor MP24 may be connected to the current source CSS' and the other end (e.g., the drain) of the fourth P-type transistor MP24 may be connected to the second node.

The gate of the third P-type transistor MP23 and the gate of the fourth P-type transistor MP24 may receive differential inputs, such as the second input signal INN and the first input signal INP, respectively. The third P-type transistor MP23 and the fourth P-type transistor MP24 may generate a differential current corresponding to the difference in levels between the second input signal INN and the first input signal INP. For example, when the hysteresis comparator COMP_H represents the first comparator COMP1 shown in FIG. 2, the internal test signal IS may be received as the first input signal INP, and the first reference voltage RV1 may be received as the second input signal INN. Also, for example, when the hysteresis comparator COMP_H represents the second comparator COMP2 shown in FIG. 2, the second reference voltage RV2 may be received as the first input signal INP, and the internal test signal IS may be received as the second input signal INN.

When the first input signal INP is greater than a value obtained by adding a first hysteresis voltage (e.g., an up hysteresis voltage) to the second input signal INN, an output signal OSP output via the output node OP' may have a logic high level ('1'). On the other hand, when the first input signal INP is less than a value obtained by subtracting a second hysteresis voltage (e.g., a down hysteresis voltage) from the second input signal INN, the output signal OSP output via the output node OP may have a logic low level ('0').

When the first input signal INP has a value much greater than the second input signal INN (e.g., is greater than the sum of the first hysteresis value and the second input signal INN) and when the output signal OSP is at a logic high level, the fifth N-type transistor MN25 and the sixth N-type transistor MN26 are blocked (e.g., turned off), and the current from the current source CSS' may flow to the ground voltage via the third N-type transistor MN23 and the fourth N-type transistor MN24.

A change in the output signal OSP from the logic high level to the logic low level occurs when the first input signal INP gradually decreases to a lower level than the second input signal INN and when the current from the current source CSS' flows via the fifth N-type transistor MN25 and the sixth N-type transistor MN26. This change may continue until the first input signal INP becomes equal to the value obtained by subtracting the second hysteresis voltage from the second input signal INN. When the first input signal INP becomes equal to the value obtained by subtracting the second hysteresis voltage from the second input signal INN, the fifth N-type transistor MN25 and the sixth N-type transistor MN26 may turn on, and the third N-type transistor MN23 and the fourth N-type transistor MN24 may turn off.

The third N-type transistor MN23 and the fourth N-type transistor MN24 may have a width ratio (e.g., width to length ratio) of 1:a, and the fifth N-type transistor MN25 and the sixth N-type transistor MN26 may have a width ratio of b:1. The first hysteresis voltage and the second hysteresis voltage may be determined by the fourth N-type transistor MN24 and the fifth N-type transistor MN25. The first hysteresis voltage may vary depending on the value of a, the magnitude of the current from the current source CSS', and/or the characteristics of the third P-type transistor MP23 or the fourth P-type transistor MP24. Also, the second hysteresis voltage may vary depending on the value of b, the magnitude of the current from the current source CSS', and/or the characteristics of the third P-type transistor MP23 or the fourth P-type transistor MP24. Therefore, the hysteresis comparator COMP_H may change the magnitudes of the first hysteresis voltage and the second hysteresis voltage according to changes in the process conditions or temperature requirements.

In the integrated circuit including the test circuit according to an example embodiment, the reference voltages for testing the internal test signal are generated by using the voltage-dividing circuit that includes the plurality of resistors connected to each other in series and constitutes the high-pass filter, and thus, even if the hysteresis characteristics of the hysteresis comparator COMP_H change due to changes in process requirements or temperature requirements, the test operation may be performed stably while satisfying the hysteresis characteristics required by the standard.

The hysteresis comparator COMP_H may further include a buffer BUF'. The buffer BUF' may receive the output signal OSP and generate an output signal VOUT'. The output signal VOUT' may represent the first test result signal TRS1 or the second test result signal TRS2 as described with reference to FIG. 2, etc.

FIG. 10 is a block diagram illustrating an electronic device 20 according to an example embodiment.

Referring to FIG. 10, the electronic device 20 may include a first device 11 and a second device 12. In an example embodiment, the first device 11 and the second device 12 may each represent the integrated circuit including the test circuit described above with reference to FIGS. 1 to 9. Also, the first device 11 and the second device 12 may each represent various hardware components included in a single user device, such as a processor, a memory device, a storage device, or a control device.

The first device 11 and the second device 12 may exchange first and second signals SIG1 and SIG2 with each other via a communication channel CH. For example, the first device 11 may include a first transmission circuit 11_1. The first transmission circuit 11_1 may transmit, as the first signal SIG1, information generated by the first device 11 to the second device 12 via the channel CH. The second device 12 may include a first reception circuit 12_1. The first reception circuit 12_1 may receive the first signal SIG1 transmitted from the first transmission circuit 11_1 via the channel CH.

Also, the second device 12 may include a second transmission circuit 12_2, and the first device 11 may include a second reception circuit 11_2. The second transmission circuit 12_2 may transmit the second signal SIG2 to the first device 11 via the channel CH, and the second reception circuit 11_2 may receive the second signal SIG2 via the channel CH.

In an example embodiment, as shown in FIG. 10, the first transmission circuit 11_1 and the second reception circuit 11_2 may be separately provided in the first device 11, and the first reception circuit 12_1 and the second transmission circuit 12_2 may be separately provided in the second device 12. However, example embodiments are not limited thereto. The first transmission circuit 11_1 and the second reception circuit 11_2 may be implemented as a single circuit, and the first reception circuit 12_1 and the second transmission circuit 12_2 may be implemented as a single circuit.

In an example embodiment, the first signal SIG1 may be distorted due to response characteristics of the channel CH or noise caused by external factors while passing through the channel CH. In this case, the information transmitted from the first transmission circuit 11_1 may differ from the information received by the first reception circuit 12_1, and thus, an error or malfunction may occur in the second device 12.

Also, the first signal SIG1 may be distorted due to defects during a process of the channel CH that connects the first device 11 to the second device 12. The test circuit according to an example embodiment may be used in a boundary scan test for detecting such defects. For example, defects detectable by the test operation in the test circuit according to an example embodiment include a case in which an output pin of the first transmission circuit 11_1 is open-circuited or connected to power supply voltage/ground voltage, a case in which output pins of the first transmission circuit 11_1 are connected to each other, or a case in which an output pin of the first transmission circuit 11_1 is connected to an output pin of another transmission circuit of the first device 11. Also, for example, defects detectable by the test operation in the test circuit according to an example embodiment include a case in which an input pin of the first reception circuit 12_1 is open-circuited or connected to power supply voltage/ground voltage, a case in which input pins of the first reception circuit 12_1 are connected to each other, or a case in which an input pin of the first reception circuit 12_1 is connected to an input pin of another reception circuit of the second device 12. Also, for example, defects detectable by the test operation in the test circuit according to an example embodiment include defects that occur in a resistor or a capacitor inside the channel CH.

An electronic device according to an example embodiment includes the test circuit that is insensitive to changes in operating voltage or operating temperature (changes in VT), thereby improving test accuracy and satisfying the requirements of the boundary scan test standard.

According to an aspect of an example embodiment, there is provided a method of controlling a test operation of an integrated circuit, the method including: controlling, based on a test signal, a voltage-dividing circuit including a plurality of resistors connected to each other in series to generate an internal test signal, a first reference signal and a second reference signal; generating, by a first low-pass filter, a first reference voltage based on the first reference signal; generating, by a second low-pass filter, a second reference voltage based on the second reference signal; comparing the first reference voltage to the internal test signal; and comparing the second reference voltage to the internal test signal.

The method may further include controlling a first selection circuit to select the first reference signal from among a plurality of first reference signals generated by the voltage-dividing circuit.

The method may further include controlling a second selection circuit to select the second reference signal from among a plurality of second reference signals generated by the voltage-dividing circuit.

The first selection circuit may include a first multiplexer, and the second selection circuit may include a second multiplexer.

The method may further include controlling a switch connected between an input node configured to receive the test signal and the voltage-dividing circuit according to a direct current mode signal.

The switch may be connected between the input node and the voltage-dividing circuit in parallel with a capacitor.

The method may further include closing the switch based on the direct current mode signal being enabled.

The method may further include opening the switch based on the direct current mode signal being disabled.

Embodiments are set out in the following clauses:
Clause 1. An integrated circuit comprising:
   a high-pass filter configured to receive a test signal and generate an internal test signal, at least one first reference signal, and at least one second reference signal;
   a first low-pass filter configured to receive the at least one first reference signal and generate a first reference voltage;
   a second low-pass filter configured to receive the at least one second reference signal and generate a second reference voltage;
   a first comparator configured to compare the first reference voltage to the internal test signal; and
   a second comparator configured to compare the second reference voltage to the internal test signal.
Clause 2. The integrated circuit of Clause 1, wherein the high-pass filter comprises:
   a coupling capacitor configured to receive the test signal; and
   a voltage-dividing circuit comprising a plurality of resistors connected to each other in series.
Clause 3. The integrated circuit of Clause 2, further comprising a switching circuit connected to the coupling capacitor in parallel and configured to be switched according to an enable signal,
   wherein the integrated circuit is further configured to operate in a direct current (DC) test mode or an alternating current (AC) test mode according to the enable signal.
Clause 4. The integrated circuit of Clause 2 or Clause 3, wherein the voltage-dividing circuit is further configured to generate the at least one first reference signal shifted upward from a common level of the internal test signal by a specific voltage level and generate the at least one second reference signal shifted downward from the common level of the internal test signal by the specific voltage level.
Clause 5. The integrated circuit of any of Clauses 1-4, wherein the high-pass filter is further configured to generate a plurality of first reference signals and a plurality of second reference signals,
   wherein the first low-pass filter is further configured to generate the first reference voltage, based on one first reference signal selected from among the plurality of first reference signals, and
   wherein the second low-pass filter is further configured to generate the second reference voltage, based on one second reference signal selected from among the plurality of second reference signals.
Clause 6. The integrated circuit of any of Clauses 1-5, wherein each of the first comparator and the second comparator comprises a comparator having no hysteresis characteristics.
Clause 7. An integrated circuit operating in a plurality of test modes, the integrated circuit comprising:
   a voltage-dividing circuit comprising a plurality of resistors connected to each other in series, wherein the voltage-dividing circuit is configured to generate an internal test signal, a first reference signal, and a second reference signal;
   a first low-pass filter configured to receive the first reference signal and generate a first reference voltage;
   a second low-pass filter configured to receive the second reference signal and generate a second reference voltage;
   a first comparator configured to compare the first reference voltage to the internal test signal; and
   a second comparator configured to compare the second reference voltage to the internal test signal,
   wherein the voltage-dividing circuit is further configured to operate as a high-pass filter in a first test mode among the plurality of test modes.
Clause 8. The integrated circuit of Clause 7, further comprising:
   a coupling capacitor configured to operate as the high-pass filter in conjunction with the voltage-dividing circuit, in the first test mode; and
   a switching circuit connected to the coupling capacitor in parallel, wherein the switching circuit is configured to turn on in a second test mode among the plurality of test modes.
Clause 9. The integrated circuit of Clause 8 or Clause 9, wherein the voltage-dividing circuit is further configured to generate the first reference signal shifted upward from a common level of the internal test signal by a specific voltage level and generate the second reference signal shifted downward from the common level of the internal test signal by the specific voltage level.
Clause 10. The integrated circuit of any of Clauses 7-9, wherein each of the first comparator and the second comparator comprises a comparator having no hysteresis characteristics.

While aspects of example embodiments have been particularly shown and described, it will be understood that various changes in form and details may be made therein without departing from the scope of the following claims.

## Claims

**1.** An integrated circuit comprising:
a voltage-dividing circuit (111) comprising a plurality of resistors connected to each other in series, wherein the voltage-dividing circuit (111) is configured to generate, based on a test signal (TS), an internal test signal (IS), at least one first reference signal (RS1), and at least one second reference signal (RS2);
a first low-pass filter (121) configured to receive the at least one first reference signal (RS1) and generate a first reference voltage (RV1);
a second low-pass filter (122) configured to receive the at least one second reference signal (RS2) and generate a second reference voltage (RV2);
a first comparator (COMP1) configured to compare the first reference voltage (RV1) to the internal test signal (IS); and
a second comparator (COMP2) configured to compare the second reference voltage (RV2) to the internal test signal (IS).

**2.** The integrated circuit of claim 1, further comprising a coupling capacitor (CC) configured to receive the test signal (TS) and connected to the voltage-dividing circuit (111).

**3.** The integrated circuit of claim 1 or claim 2, wherein the voltage-dividing circuit (111) is configured to generate a plurality of first reference signals (RS11, RS1n) and a plurality of second reference signals (RS21, RS2n),
wherein the first low-pass filter (121) is further configured to generate the first reference voltage (RV1), based on one first reference signal (RS1) selected from among the plurality of first reference signals (RS11, RS1n), and
wherein the second low-pass filter (122) is further configured to generate the second reference voltage (RV2), based on one second reference signal (RS2) selected from among the plurality of second reference signals (RS21, RS2n).

**4.** The integrated circuit of any preceding claim, wherein each of the first comparator (COMP1) and the second comparator (COMP2) comprises a comparator having no hysteresis characteristics.

**5.** The integrated circuit of any of claims 1-3, wherein each of the first comparator (COMP1) and the second comparator (COMP2) comprises a hysteresis comparator having hysteresis characteristics.

**6.** The integrated circuit of any preceding claim further comprising
a high-pass filter (110) configured to receive the test signal (TS) and generate the internal test signal (IS), the at least one first reference signal (RS1), and the at least one second reference signal (RS2), wherein the high-pass filter (110) comprises a coupling capacitor (CC) configured to receive the test signal (TS) and the voltage-dividing circuit (111).

**7.** The integrated circuit of claim 6, further comprising a switching circuit (SW) connected to the coupling capacitor (CC) in parallel and configured to be switched according to an enable signal (DC_EN),
wherein the integrated circuit is further configured to operate in a direct current test mode or an alternating current test mode according to the enable signal (DC_EN).

**8.** The integrated circuit of claim 6 or claim 7, wherein the voltage-dividing circuit (111) is further configured to generate the at least one first reference signal (RS1) shifted upward from a common level of the internal test signal (IS) by a specific voltage level and generate the at least one second reference signal (RS2) shifted downward from the common level of the internal test signal (IS) by the specific voltage level.

**9.** The integrated circuit of any of claims 6-8, wherein the high-pass filter (110) is further configured to generate a plurality of first reference signals (RS11, RS1n) and a plurality of second reference signals (RS21, RS2n),
wherein the first low-pass filter (121) is further configured to generate the first reference voltage (RV1), based on one first reference signal (RS1) selected from among the plurality of first reference signals (RS11, RS1n), and
wherein the second low-pass filter (122) is further configured to generate the second reference voltage (RV2), based on one second reference signal (RS2) selected from among the plurality of second reference signals (RS21, RS2n).

**11.** A method of controlling a test operation of an integrated circuit, the method comprising:
controlling, based on a test signal (TS), a voltage-dividing circuit (110) including a plurality of resistors connected to each other in series to generate an internal test signal (IS), a first reference signal (RS1) and a second reference signal (RS2);
generating, by a first low-pass filter (121), a first reference voltage (RV1) based on the first reference signal (RS1);
generating, by a second low-pass filter (122), a second reference voltage (RV2) based on the second reference signal (RS2);
comparing the first reference voltage (RV1) to the internal test signal (IS); and
comparing the second reference voltage (RV2) to the internal test signal (IS).

**12.** The method of claim 11, further comprising controlling a first selection circuit (131) to select the first reference signal (RS1) from among a plurality of first reference signals (RS11, RS1n) generated by the voltage-dividing circuit (110).

**13.** The method of claim 11 or claim 12, further comprising controlling a second selection circuit (132) to select the second reference signal (RS2) from among a plurality of second reference signals (RS21, RS2n) generated by the voltage-dividing circuit (110).

**14.** The method of any of claims 11-13, further comprising controlling a switch (SW) connected between an input node configured to receive the test signal (TS) and the voltage-dividing circuit (110) according to a direct current mode signal (DC_EN).

**15.** The method of claim 14 wherein:
the switch (SW) is connected between the input node and the voltage-dividing circuit (110) in parallel with a capacitor (CC);
the method further comprises:
closing the switch (SW) based on the direct current mode signal (DC_EN) being enabled; and
opening the switch (SW) based on the direct current mode signal (DC_EN) being disabled.
